# EUROPÄISCHE PATENTANMELDUNG

(11) **EP 1 691 595 A2**
(43) Veröffentlichungstag der Anmeldung: **16.08.2006**
(21) Anmeldenummer: 06101265.4
(22) Anmeldetag: 03.02.2006
(51) Int. Cl.: H05K 7/20, H01L 23/40

(54) **Gebläseregler für ein Fahrzeug**

(30) Priorität: 10.02.2005 DE 102005005944
(71) Anmelder: Behr-Hella Thermocontrol GmbH, 70190 Stuttgart (DE)
(72) Erfinder: Knittel, Otto, 59494, Soest (DE); Röhling, Dieter, 59558, Lippstadt (DE)
(74) Vertreter: Hilleringmann, Jochen

(57) **Zusammenfassung**

Der Gebläseregler für ein Fahrzeug ist versehen mit einer elektrischen Schallung (12) zur Ansteuerung eines Gebläses, wobei die elektrische Schaltung (12) mindestens einen Ansteuertransistor (16) für das Gebläse und einem thermisch leitenden Trägerkörper (22) aufweist, mit dem der Ansteuertransistor (16) thermisch gekoppelt ist, wobei der Trägerkörper (22) zur thermischen Ankopplung an eine wie eine Wärmesenke wirkende Fahrzeugkomponente (32) mit dieser mechanisch verbindbar ist.

## Beschreibung

Die Erfindung betrifft einen Gebläseregler für ein Fahrzeug und insbesondere die Kühlung eines Ansteuertransistors für ein Fahrzeug-Gebläse

Lineargebläseregler für Kfz-Heizungsgebläse weisen eine hohe Verlustleistung von bis zu 100 W bei mittleren Gebläsespannungen im Bereich der halben Versorgungsspannung auf. Um diese hohen Verlustleistungen abführen zu können, ist es bekannt, dass das die hohe Verlustleistung erzeugende Bauteil, bei dem es sich um einen Ansteuertransistor für das Heizungsgebläse handelt, thermisch mit einem Kühlkörper zu verbinden und diesen Kühlkörper dem Gebläseluftstrom auszusetzen. Derartige Kühlkörper sind bezüglich ihrer Herstellung recht aufwendig und damit kostenintensiv.

Der Erfindung liegt die Aufgabe zugrunde, einen Gebläseregler für ein Fahrzeug-Gebläse zu schaffen, der über eine verbesserte und insbesondere weniger aufwendige Kühlung verfügt.

Zur Lösung dieser Aufgabe wird mit der Erfindung ein Gebläseregler für ein Fahrzeug vorgeschlagen, der versehen ist mit
- einer elektrischen Schaltung zur Ansteuerung eines Gebläses,
- wobei die elektrische Schaltung mindestens einen Ansteuertransistor für das Gebläse aufweist, und mit
- einem thermisch leitenden Trägerkörper, mit dem der Ansteuertransistor thermisch gekoppelt ist,
- wobei der Trägerkörper zur thermischen Ankopplung an eine wie eine Wärmesenke wirkende Fahrzeugkomponente mit dieser mechanisch verbindbar ist.

Nach der Erfindung ist also sinngemäß vorgesehen, den mindestens einen Ansteuertransistor der elektrischen Schaltung des Gebläsereglers thermisch mit einer von einer Fahrzeugkomponente gebildeten Temperatursenke zu koppeln. Dadurch kann der kostenintensive Kühlkörper eingespart werden. Bei der Fahrzeugkomponente handelt es sich beispielsweise um den Heizungswärmetauscher oder einen Verdampfer einer Kfz-Heizungsanlage bzw. Kfz-Klimaanlage oder aber auch um dem Motorblock oder die Karosserie des Fahrzeuges. Entscheidend ist, dass die Fahrzeugkomponente eine große thermische Masse mit hoher Wärmekapazität darstellt.

Was die mechanische Verbindung des Trägerkörpers mit der die Temperatursenke darstellenden Fahrzeugkomponente anbelangt, so ist diese vorzugsweise durch eine relativ großflächige Anlage beider Teile gekennzeichnet. Hier kommt beispielsweise ein reibschlüssige oder stoffschlüssige Verbindung beider Teile in Frage. So ist beispielsweise eine Presspassung vorteilhaft. Vorteilhaft ist es, wenn beide Teile miteinander verschraubbar sind. Dann kann nämlich der zu kühlende Ansteuertransistor bereits thermisch mit dem Trägerkörper gekoppelt sein, bevor dieser mit der Fahrzeugkomponente verschraubt wird, ohne dass zu befurchten ist, dass der Ansteuertransistor bei der Verschraubung mit der Fahrzeugkomponente Schaden erleidet.

Wenn der Trägerkörper aus Kupfer besteht oder zumindest an seiner den Ansteuertransistor tragenden Fläche Kupfer aufweist, so ist die thermische Kopplung von Ansteuertransistor und Trägerkörper löttechnisch realisierbar, indem das Gehäuse des Ansteuertransistors mit der Kupferfläche des Trägerkörpers verlötet ist. Die Verschraubung des Trägerkörpers mit der Fahrzeugkomponente stellt einen sehr guten thermischen Übergang von Trägerkörper zur Fahrzeugkomponente dar. Durch die Gewindeausbildung an Trägerkörper und Fahrzeugkomponente kommt es zu einer relativ großflächigen Kontaktierung beider Teile, was für den Wärmefluss vom Trägerkörper zur Fahrzeugkomponente vorteilhaft ist.

Zweckmäßig ist es des weiteren, wenn der Trägerkörper den gesamten Gebläseregler, also dessen Gehäuse mit der elektrischen Schaltung und dem mindestens einen Ansteuertransistor trägt. Die gesamte Einheit kann dann thermisch mit der Fahrzeugkomponente gekoppelt werden, was für den Gebläseregler, wie oben bereits beschrieben, dann besonders schonend erfolgen kann, wenn der Trägerkörper mit der Fahrzeugkomponente verschraubbar ist.

Bezüglich der Verschraubbarkeit ist es ferner von Vorteil, wenn der Trägerkörper ein Außengewinde aufweist, das mit einem Innengewinde an der Fahrzeugkomponente in Eingriff bringbar ist. Beispielsweise und vorteilhafterweise ist der Trägerkörper durch eine Schraube gebildet, deren Schraubenkopf den mindestens einen Ansteuertransistor (und gegebenenfalls die weiteren Teile des Gebläsereglers) trägt und sich mittels eines Werkzeuges (Zange, Schraubenschlüssel oder dergleichen) zwecks Verschraubung mit der die Temperatursenke bildenden Fahrzeugkomponente handhaben lässt.

Die Erfindung wird nachfolgend anhand eines Ausführungsbeispiels unter Bezugnahme auf die Zeichnung näher erläutert. In dieser zeigen im Einzelnen:
- Fig. 1.: eine schematische Darstellung des mechanischen Aufbaus eines Gebläsereglers mit erfindungsgemäß mit einer Fahrzeugkomponente verschraubbarem Trägerkörper für einen Ansteuertransistor und
- Fig. 2: eine schematische Darstellung einer möglichen Anordnung des Gebläsereglers an einem Heizungswärmetauscher einer Kfz-Neizungsanlage im mit diesem Wärmetauscher verschraubten Zustand.

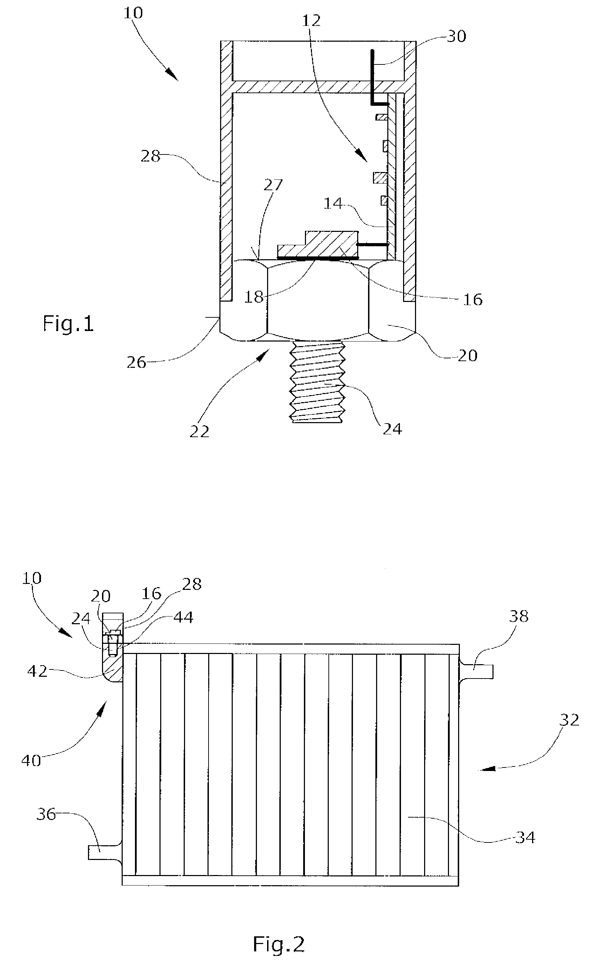

Fig. 1 zeigt einen Längsschnitt durch einen Lineargebläseregler 10 für ein Kfz-Gehläse. Der Lineargebläseregler 10 weist eine elektrische Schaltung 12 auf, die auf einer Platine 14 angeordnet ist. Bestandteil der elektrischen Schaltung 12 ist unter anderem auch ein Ansteuertransistor 16 zur Ansteuerung des (nicht dargestellten) Kfz-Gebläses, Der Transistor 16 ist über eine Lötschicht 18 mit dem Kopf 20 einer Kupferschraube 22 verlötet, die einen vom Schraubenkopf 20 abstehenden Gewindebolzen 24 aufweist. Der Schraubenkopf 20 weist eine Außensechskant-Umfangsfläche 26 auf. Auf der stirnseitigen Endfläche 27 des Schraubenkopfes 20 ist der Transistor 16 über die Lötschicht 18 befestigt und somit mit der Kupferschraube 22 thermisch gekoppelt. Über den Schraubenkopf 20 ist ein Gehäuse 28 gestülpt, in dem die Platine 14 mit Steckerelementen 30 untergebracht ist, welche ihrerseits aus dem Gehäuse 28 herausgeführt sind.

Fig. 2 zeigt eine mögliche Verschraubungsposition des Lineargebläsereglers 10 an dem Heizungswärmetauscher 32 einer Fahrzeugheizungs- oder Klimaanlage. Das Gehäuse 34 des Heizungswärmetauschers 32 weist einen Einlass 36 und einen Auslass 38 auf, über die der Heizungswärmetauscher 32 in den Motorkühlwasserkreislauf eingebunden ist. Das Gehäuse 34 weist bei 40 eine Materialverdickung 42 auf, in der eine Sacklochbohrung 44 mit Innengewinde (nicht dargestellt) ausgebildet ist, mit der der Gewindebolzen 24 der Kupferschraube 22 verschraubt ist. Die Kupferschraube 22 stellt den Trägerkörper für den Ansteuertransistor 16 dar. Der flächige Kontakt zwischen Kupferschraube 22 und Heizungswärmetauscher 32 erfolgt längs des Gewindes des Gewindebolzens 24 und der Unterseite des Schraubenkopfes 20. Auch bei hohen Wärmetauschertemperaturen stellt der Heizungswärmetauscher 32 eine sehr große Temperatursenke dar, so dass die vom Transistor 16 erzeugte Verlustwärme zum Heizungswärmetauscher 32 abgeführt werden kann, wobei diese abgeführte Wärme keinen nennenswerten Anstieg der Gehäusetemperatur des Heizungswärmetauschers 32 verursacht. Unter diesem Aspekt eignet sich auch der Motorblock eines Fahrzeuges als Temperatursenke. Selbstverständlich eignet sich insbesondere eine gekühlte Fahrzeugkomponente als Temperatursenke, um die es sich beispielsweise bei dem Verdampfer der Kfz-Klimaanlage handelt. Die in den Fign. 1 und 2 gezeigte Schraublösung für die mechanische und thermische Verbindung von Lineargebläseregler 10 und Heizungswärmetauscher 32 hat den Vorteil, dass bei der Montage keinerlei Abscherkräfte auf die Lötverbindung zwischen dem Ansteuertransistor 16 und dem durch die Schraube 22 realisierten Trägerkörper ausgeübt werden. Damit genügt diese Ausfuhrungsform hohen Qualitätsansprüchen.

### BEZUGSZEICHENLISTE

- 10: Lineargebläseregler
- 12: elektrische Schaltung
- 14: Platine
- 16: Ansteuertransistor
- 18: Lötschicht
- 20: Schraubenkopf
- 22: Schraube
- 24: Gewindebolzen der Schrauben
- 26: Außensechskant-Umfangsfläche
- 27: stirnseitigen Endfläche
- 28: Gehäuse
- 30: Steckerelementen
- 32: Heizungswärmetauscher
- 34: Gehäuse
- 36: Einlass
- 38: Auslass
- 40: Ort der Materialverdickung
- 42: Materialverdickung
- 44: Sacklochbohrung

## Patentansprüche

1. Gebläseregler für ein Fahrzeug, mit
- einer elektrischen Schaltung (12) zur Ansteuerung eines Gebläses,
- wobei die elektrische Schaltung (12) mindestens einen Ansteuertransistor (16) für das Gebläse aufweist und
- einem thermisch leitenden Trägerkörper (22), mit dem der Ansteuertransistor (16) thermisch gekoppelt ist,
**dadurch gekennzeichnet, dass**
- der Trägerkörper (22) zur thermischen Ankopplung an eine wie eine Wärmesenke wirkende Fahrzeugkomponente (32) mit dieser mechanisch verbindbar ist.

2. Gebläseregler nach Anspruch 1, **dadurch gekennzeichnet, dass** der Trägerkörper (22) mit der Fahrzeugkomponente (32) verschraubbar ist.

3. Gebläseregler nach Anspruch 2, **dadurch gekennzeichnet, dass** der Trägerkörper (22) einen Gewindebolzen (24) oder eine Gewindebohrung zum Schraubeingriff mit einer Gewindebohrung (44) bzw. einem Gewindebolzen der Fahrzeugkomponente (32) aufweist.

4. Gebläseregler nach Anspruch 2 oder 3, **dadurch gekennzeichnet, dass** der Trägerkörper (22) eine Aufnahme zum Zusammenwirken mit einer Zange, einem Schraubenschlüssel und/oder -dreher o.dgl. aufweist.

5. Gebläseregler nach Anspruch 4, **dadurch gekennzeichnet, dass** der Trägerkörper (22) als Schraube mit einem Schaft und einem eine Außensechskant-Fläche (26) aufweisenden Schraubenkopf (20) ausgebildet ist.

6. Gebläseregler nach einem der Ansprilche 1 bis 5, **dadurch gekennzeichnet, dass** die Fahrzeugkomponente (32) der Motorblock oder die Karosserie eines Fahrzeuges oder der Heizungswärmetauscher oder der Verdampfer der Heizungsanlage eines Fahrzeuges ist.

7. Gebläseregler nach einem der Ansprüche 1 bis 6, **dadurch gekennzeichnet, dass** der Trägerkörper (22) zumindest an seiner den Ansteuertransistor (16) tragenden Fläche (28) Kupfer aufweist und dass das Gehäuse des Ansteuertransistors (16) mit der Kupferfläche verlötet ist.

8. Gebläse nach einem der Ansprüche 1 bis 7, **dadurch gekennzeichnet, dass** der Trägerkörper (22) auch ein Gehäuse (28) mit der in diesem angeordneten elektrischen Schaltung (12) und dem mindestens einen Ansteuertransistor (16) trägt.
